# FASCICULE DE BREVET EUROPEEN

(11) **EP 0 664 588 B1**
(45) Date de publication et mention de la délivrance du brevet: **21.06.2000**
(21) Numéro de dépôt: 95400096.4
(22) Date de dépôt: 18.01.1995
(51) Int. Cl.: H01S 5/10, H01S 5/02, G02F 1/025

(54) **Structure semiconductrice à réseau de diffraction virtuel**
Halbleiterstruktur mit virtuellem Beugungsgitter
Semiconductor structure with virtual diffraction lattice

(30) Priorité: 20.01.1994 FR 9400587
(43) Date de publication de la demande: 26.07.1995
(73) Titulaire: FRANCE TELECOM, 75015 Paris (FR)
(72) Inventeur: Kazmierski, Christophe, F-91420 Morangis (FR); Robein, Didier, F-92260 Fontenay-aux-Roses (FR)
(74) Mandataire: Dubois-Chabert, Guy

(56) Documents cités:
- FR-A- 2 684 498
- GB-A- 2 106 706
- PATENT ABSTRACTS OF JAPAN vol. 10, no. 113 (E-399) (2170) 26 Avril 1986 & JP-A-60 247 986 (FUJITSU) 7 Décembre 1985
- PATENT ABSTRACTS OF JAPAN vol. 13, no. 371 (E-807) 17 Août 1989 & JP-A-01 124 279 (MATSUSHITA ELECTRIC) 17 Mai 1989
- PATENT ABSTRACTS OF JAPAN vol. 9, no. 101 (P-353) (1824) 2 Mai 1985 & JP-A-59 226 320 (MATSUSHITA) 19 Décembre 1984
- 1992 IEEE MTT-S INTERNATIONAL MICROWAVE SYMPOSIUM DIGEST, 1992, NEW YORK, US pages 571 - 574, XP343103 M.T. CAMARGO SILVA ET AL. 'MMIC Based Optical Modulator Design'
- OFC/IOOC '93, TECHNICAL DIGEST, 1993, SAN DIEGO, US pages 160 - 161 T.L. KOCH 'Gain-Coupled DFB Lasers'

## Description

La présente invention concerne une structure semiconductrice, comprenant :
- une première couche semiconductrice ayant une premier type de dopage,
- une couche semiconductrice intermédiaire, qui est placée au dessus de la première couche semiconductrice, et
- une deuxième couche semiconductrice ayant un deuxième type de dopage opposé au premier type, cette deuxième couche semiconductrice étant placée au dessus de la couche semiconductrice intermédiaire, et formant, avec la première couche semiconductrice, une jonction P-N, les largeurs de bande interdite des première et deuxième couches semiconductrices étant supérieures à celle de la couche semiconductrice intermédiaire.

Elle s'applique notamment au domaine de la transmission d'informations sous forme de lumière qui peut être guidée, par exemple par des fibres optiques, ou non guidée.

L'invention permet par exemple de réaliser divers dispositifs semiconducteurs à double hétérostructure, en particulier des diodes lasers, des modulateurs de lumière, des filtres de lumière et des amplificateurs de lumière.

On connaît des diodes lasers de ce type dont une partie apte à guider la lumière a la forme d'un ruban et dans lesquels une contre-réaction optique a lieu, soit par réflexion de la lumière sur des miroirs constitués par des faces perpendiculaires à la partie guidant la lumière, faces qui peuvent être clivées ou gravées, soit au moyen de réseaux de diffraction ("*diffraction gratings"*) qui sont des structures périodiques induisant une modulation spatiale de l'indice optique ou du gain dans ces diodes lasers.

Ces réseaux de diffraction, grâce au filtrage par diffraction optique qu'ils provoquent, engendrent une contre-réaction distribuée ("*distributed feedback"*), ce qui conduit à un fonctionnement monomode longitudinal (fonctionnement à une seule fréquence) des diodes lasers et des filtres comportant de tels réseaux de diffraction.

Ces lasers et ces filtres monofréquence trouvent des applications partout où une seule longueur d'onde doit être émise ou sélectionnée, par exemple dans des systèmes de télécommunications optiques utilisant plusieurs longueurs d'ondes, dans des lasers pour pompage optique et dans le domaine de la métrologie Lidar.

Ces lasers monofréquence ont l'avantage d'avoir un faible encombrement spectral sous modulation.

Ceci est exploité dans les système de télécommunications optiques, dans les systèmes de transmission rapide d'informations par micro-ondes et pour la génération d'impulsions optiques cohérentes.

Dans un laser à contre-réaction distribuée ("*distributed feedback laser*"), plus simplement appelé "laser DFB", de type classique, la contre-réaction est obtenue grâce à un réseau périodique de matériaux alternés, d'indices optiques différents, réseau qui est placé le long de la direction de propagation de la lumière et qui est plus simplement appelé "réseau d'indice" (voir le document (1) qui, comme les autres documents cités dans la présente demande, est mentionné à la fin de la présente description).

Ce type de laser DFB a un gros inconvénient : dans ce laser, le rapport de suppression du mode secondaire SMSR ("*side mode suppression ratio*") est très sensible aux positions respectives des faces clivées réfléchissantes et du réseau d'indice, positions qui sont intrinsèquement aléatoires à l'échelle submicronique (voir le document (2)).

De plus, si l'on élimine la réflectivité de ces faces par un traitement anti-reflet approprié, le laser devient bi-mode.

Pour remédier à cet inconvénient, l'une des solutions les plus utilisées consiste à fabriquer au moins deux réseaux de diffraction qui sont spatialement déphasés dans le même laser (voir le document 3)).

Cela permet un fonctionnement monofréquence du laser mais ne permet pas de diminuer la sensibilité à la position des faces réfléchissantes.

Cependant, une solution théorique au problème posé par ce type de laser DFB à réseau d'indice existait depuis plus de vingt ans, comme cela apparaît dans le document (4).

En effet, il est indiqué dans ce document (4) que le fonctionnement bi-mode d'un laser DFB à réseau d'indice peut devenir parfaitement monomode si la modulation d'indice optique est remplacée par une modulation du gain du laser (on parle alors de "laser DFB à réseau de gain pur").

Cependant, la première démonstration pratique de cette prévision théorique n'a eu lieu qu'en 1988 (voir le document (5)), en raison de problèmes technologiques liés à la fabrication d'un réseau de gain pur.

Malgré l'intérêt croissant pour les lasers DFB à réseau de gain pur, les solutions technologiques pour réaliser de tels lasers sont encore limitées et manquent bien souvent de souplesse.

On connaît actuellement deux solutions pour obtenir des lasers DFB à réseau de gain pur (on parle de "couplage par le gain" à propos de tels lasers).

La première solution, directement issue de la technologie des réseaux d'indice, consiste à remplacer le matériau dont l'indice optique diffère de celui du matériau qui l'entoure, par un matériau apte à absorber l'onde optique (voir les documents (5), (6) et (7)).

On obtient ainsi une modulation spatiale d'absorption et une modulation de facteur de confinement conjuguées qui, d'une certaine manière, réalisent la fonction globale de modulation de gain, étant donné que le gain est plus grand que l'absorption.

L'un des inconvénients de cette première solution est d'augmenter les pertes optiques dans la structure guidant la lumière, ce qui se traduit par une augmentation du courant de seuil dans le cas des diodes lasers.

Cette augmentation des pertes optiques peut être limitée si l'on utilise un matériau semiconducteur de type N pour réaliser le réseau absorbant (voir le document (8)).

Un autre inconvénient de cette première solution est liée à la nature du matériau absorbant, dont la bande interdite doit avoir une largeur proche de celle du matériau de la couche active.

Dans ce cas, on obtient à la fois une absorption et un fort saut d'indice optique, ce qui conduit à un couplage complexe (c'est-à-dire à un dispositif comportant à la fois un réseau d'indice et un réseau de gain pur), à forte prédominance du couplage par l'indice optique.

On peut donc reprocher à cette première solution un manque de souplesse si l'on veut ajuster, indépendamment l'un de l'autre, l'amplitude du gain par rapport à l'amplitude de l'indice optique et le déphasage spatial du gain par rapport à l'indice optique.

De plus, il paraît très difficile, voire impossible, de réaliser, avec cette première solution, un couplage par le gain pur.

La deuxième solution connue consiste à réaliser un réseau amplificateur par gravure directe de la couche active du laser (voir les documents (9) et (10)).

Avec une telle configuration, on obtient, sans pertes optiques supplémentaires, la modulation du gain, la modulation du facteur de confinement et une forte modulation d'indice optique.

On retrouve donc, mis à part les pertes, les mêmes inconvénients qu'avec la première solution.

Il semble toutefois qu'une réalisation d'un réseau de gain pur soit possible, bien que très délicate à mettre en oeuvre du point de vue technologique, par compensation de la modulation d'indice, modulation qui est due à la gravure de la couche active, grâce à des sauts positif et négatif d'indice des couches de confinement (voir le document (10)).

On peut ainsi envisager de maîtriser la composante relative au gain dans le couplage complexe par rapport à la composante relative à l'indice optique.

Cependant, l'inconvénient majeur de tous ces composants à réseaux amplificateurs connus réside dans la nécessité de graver directement la couche active de ces composants, gravure qui induit des défauts cristallins lorsqu'on fait croître des couches adjacentes à la couche active et qui peut être également incompatible avec l'exigence de fiabilité des composants.

La présente invention concerne une structure semiconductrice comportant un réseau de diffraction virtuel, c'est-à-dire une structure semiconductrice dans laquelle on peut faire apparaître lorsqu'on le souhaite un réseau de diffraction, réseau dont on peut d'ailleurs moduler l'amplitude.

La présente invention utilise un agencement périodique qui permet la création, dans la structure, d'un réseau de porteurs de charge ou d'un champ électrique modulé lorsque cette structure est convenablement commandée (par injection de courant électrique ou par polarisation en inverse).

On obtient ainsi un réseau de diffraction dont le pas est d'ailleurs égal à la période de l'agencement que comporte la structure.

Une structure conforme à l'invention peut comporter un réseau (virtuel) de gain pur (couplage par le gain) ou un réseau (virtuel) d'indice optique (couplage par l'indice) ou encore un réseau (virtuel) mixte, à savoir un réseau (virtuel) d'indice et de gain pur (couplage complexe).

La présente invention permet de résoudre le problème de la réalisation, de façon simple, d'un couplage par le gain pur, dans un dispositif optoélectronique comportant une couche active, sans avoir à graver cette couche active, et après la fabrication de celle-ci.

L'invention permet également de disposer d'une souplesse, du point de vue technologique, pour concevoir des réseaux à couplage complexe, c'est-à-dire des structures comportant à la fois un réseau d'indice et un réseau de gain pur (réseaux qui peuvent d'ailleurs être spatialement en phase ou en opposition de phase).

Patent Abstract of Japan, vol. 10 n° 113 (E - 399 2170 26 avril 1986 et JP-A-60 247 986 décrivent un laser DFB comprenant un réseau de diffraction fixe.

De façon précise, la présente invention a pour objet une structure semiconductrice conformément à la revendication 1.

Lesdites premières zones de cette structure peuvent être non intentionnellement dopées, leur dopage étant alors très inférieur à 10¹⁷ cm⁻³.

La période de l'agencement est choisie en fonction de la valeur de la longueur d'onde relative aux ondes, par exemple électro-magnétiques, avec lesquelles la structure est destinée à être utilisée : on donne à l'agencement une période de l'ordre de grandeur de cette longueur d'onde (c'est-à-dire de l'ordre de 1 à 10 fois cette longueur d'onde).

De préférence, afin de faciliter la fabrication de la structure objet de l'invention, l'épaisseur desdites premières zones est inférieure ou environ égale à la période de l'agencement périodique.

Certes on connaît, par le document (12), une structure semiconductrice comprenant un arrangement périodique où des zones régulièrement espacées les unes des autres ont un type de dopage opposé à celui de la couche semiconductrice dans laquelle ces zones se trouvent. Cependant le dopage de ces zones est élevé (10¹⁹ cm⁻³). Il en résulte des pertes optiques élevées dans cette structure connue.

La présente invention remédie à cet inconvénient grâce à l'utilisation desdites premières zones dont le dopage est plus faible (inférieur à 10¹⁹ cm⁻³).

De plus, dans le document (12), il est indiqué que l'épaisseur desdites zones doit être suffisamment supérieure à la longueur de diffusion des porteurs minoritaires dans ces zones (condition I). L'utilisation d'un fort dopage de ces dernières induit une faible longueur de diffusion, ce qui permet la fabrication de structures du genre de celles qui sont décrites dans le document (12).

Cependant, on a vu qu'un fort dopage conduisait à des pertes optiques élevées. En abaissant ce dopage, la longueur de diffusion augmente et l'enseignement du document (12) conduit alors à des zones périodiques de grande épaisseur, extrêmement difficiles à réaliser du fait de l'espacement très faible entre ces zones (espacement qui est de l'ordre de grandeur de la longueur d'onde des ondes qui interagissent avec la structure). Même si on parvenait à réaliser ces zones, l'étape suivante de recroissance épitaxiale du matériau semiconducteur destiné à entourer ces zones serait aussi extrêmement difficile à mettre en oeuvre (ce matériau ne pourrait quasiment pas pénétrer entre ces zones).

Dans la présente invention, on n'impose pas la condition I ci-dessus. Le non-respect de cette condition n'empêcherait d'ailleurs pas la structure de fonctionner car la jonction semiconductrice existant entre lesdites zones et leur environnement n'est pas polarisée.

Il est à noter que la présente invention peut être mise en oeuvre par exemple avec des matériaux de la famille InP et avec des dopages de l'ordre de 10¹⁷ cm⁻³ à 10¹⁸ cm⁻³, d'où des longueurs de diffusion jusqu'à 100 fois supérieures à celles que l'on obtient en suivant l'enseignement du document (12). Avec de telles longueurs de diffusion, les structures décrites dans ce document (12) seraient quasiment irréalisables : cela nécessiterait en effet de faire des gravures d'un matériau semiconducteur profondes de 0,5 µm ou plus avec une périodicité de 0,2 µm par exemple.

On connaît aussi, par le document (13), une structure semiconductrice comprenant un arrangement périodique de zones semi-isolantes régulièrement espacées les unes des autres. Cependant une telle structure présente des pertes optiques dues au matériau semi-isolant. De plus, les zones semi-isolantes ne sont pas réalisables du côté P de la structure (les zones semi-isolantes seraient alors dans un semiconducteur de type P) car, dans ce cas, elles perdent leur caractère semi-isolant à cause de phénomènes d'interdiffusion entre les dopants (par exemple Be, Cd, Zn) de type P et les dopants (typiquement le fer) conduisant à un matériau semi-isolant. A ce sujet, on se reportera au document (14) . La présente invention ne présente pas ces inconvénients.

Selon un premier mode de réalisation particulier, la structure objet de l'invention comprend en outre des moyens d'injection de courant électrique dans la jonction P-N, l'agencement périodique étant apte à moduler spatialement l'arrivée du courant électrique dans la couche intermédiaire.

Selon un deuxième mode de réalisation particulier, cette structure comprend en outre des moyens de polarisation en inverse de la jonction P-N, l'agencement périodique étant apte à moduler spatialement le champ électrique dans cette jonction P-N.

Selon un mode de réalisation préféré de la structure objet de l'invention, l'agencement périodique est formé du côté de la deuxième couche semiconductrice.

Le réseau de diffraction que la structure objet de l'invention permet de créer, peut servir à diffracter une onde électromagnétique non guidée dans la structure et tombant sur celle-ci, ou, au contraire, une onde électromagnétique guidée dans la structure.

Pour une utilisation particulière de l'invention, correspondant à ce dernier cas, la couche semiconductrice intermédiaire est une couche de guidage de lumière et les première et deuxième couches semiconductrices sont des couches de confinement aptes à confiner la lumière dans la couche intermédiaire, de manière à former un dispositif opto-électronique à contre-réaction distribuée.

La couche de guidage de lumière peut être une couche active qui constitue un milieu amplificateur de lumière, l'agencement périodique permettant ainsi la modulation spatiale du gain de la structure.

Au contraire, la couche de guidage de lumière peut être une couche passive qui n'amplifie pas la lumière qu'elle guide, l'agencement périodique permettant ainsi la formation d'un réseau d'indice dans la structure.

Dans l'invention, les zones qui alternent les uns avec les autres peuvent avoir des indices optiques différents l'un de l'autre pour former un réseau d'indice.

La présente invention sera mieux comprise à la lecture de la description d'exemples de réalisation donnés ci-après, à titre purement indicatif et nullement limitatif, en faisant référence aux dessins annexés sur lesquels :
- la figure 1 illustre schématiquement le principe d'une structure conforme à la présente invention,
- la figure 2 illustre schématiquement la possibilité, avec la présente invention, d'obtenir des réseaux à couplage complexe où la part de gain et la part d'indice peuvent être ajustées indépendamment l'une de l'autre,
- les figures 3A et 3B sont des vues schématiques et partielles de structures conformes à l'invention, qui utilisent un agencement périodique à zones semiconductrices de type N alternant avec des zones semiconductrices de type P,
- les figures 4A et 4B sont des vues schématiques et partielles d'autres structures conformes à l'invention, qui utilisent un agencement périodique dans lequel des zones semi-isolantes ou des zones semiconductrices non dopées alternent avec des zones semiconductrices dopées,
- la figure 5 est une vue schématique et partielle d'une structure semiconductrice utilisant un agencement périodique formé d'électrodes élémentaires régulièrement espacées les unes des autres,
- la figure 6 est une vue schématique et partielle d'une autre structure semiconductrice qui comporte, en plus de celle de la figure 5, un réseau de diffraction,
- la figure 7 est une vue schématique et partielle d'un mode de réalisation particulier de la structure objet de l'invention, et
- les figures 8 à 10 illustrent schématiquement des étapes d'un procédé de fabrication de la structure de la figure 7.

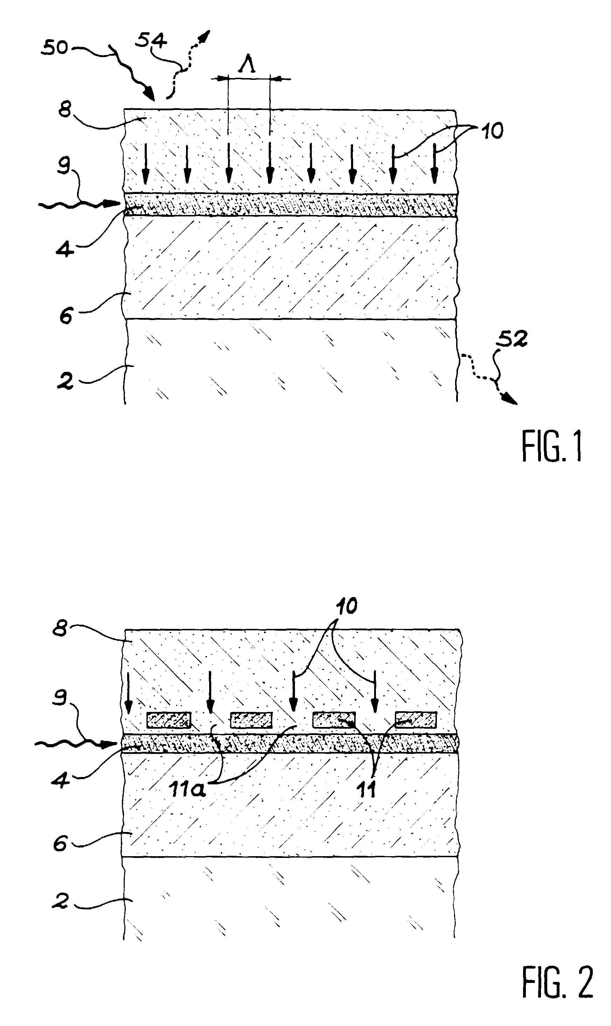

Le principe d'une structure conforme à l'invention est schématiquement illustré par la figure 1 sur laquelle on voit un substrat semiconducteur 2 sur lequel repose un empilement de couches semiconductrices comprenant une couche semiconductrice 4 de guidage de lumière entre deux couches semiconductrices 6 et 8 dont les dopages sont opposés et qui forment ainsi une jonction P-N, ces couches 6 et 8 ayant des largeurs de bande interdite supérieures à celle de la couche 4 et étant aptes à confiner la lumière dans la couche 4.

Cette couche 4, comprise entre la couche de confinement inférieure 6, par exemple de type N, et la couche de confinement supérieure 8, par exemple de type P, peut-être passive (simple guidage de lumière) ou, au contraire, active (et constitue alors un milieu amplificateur de la lumière).

Selon l'invention, l'empilement est muni d'un agencement périodique formé dans la couche 8 et apte à moduler spatialement un courant électrique injecté dans la jonction P-N, la période Λ de cet agencement étant de l'ordre de grandeur de la longueur d'onde de la lumière 9 que la couche 4 est destinée à guider.

Les flèches 10 symbolisent cette modulation spatiale.

Le courant ainsi modulé conduit à des variations de concentration des porteurs de charge dans la couche 4, porteurs qui, à leur tour, engendrent une modulation spatiale du gain lorsque la couche de guidage 4 est un milieu actif ou une modulation spatiale de l'indice optique dans la couche 4 lorsque celle-ci est une couche passive (le dispositif étant alors destiné à constituer par exemple un guide optique ou un filtre optique).

On obtient ainsi un réseau de gain pur ou un réseau d'indice, dont le pas est égal à la période Λ de l'agencement périodique dont est muni la structure.

La figure 2 illustre schématiquement et partiellement l'association d'un réseau d'indice optique à la structure de la figure 1 où la couche de guidage 4 est supposée active (milieu amplificateur de lumière).

Ce réseau d'indice optique a un pas égal à la période Λ de l'agencement apte à moduler le courant électrique et comprend, dans la couche 8, des zones 11 dont l'indice optique est différent de celui de cette couche 8 et qui alternent avec des zones 11a de cette couche 8.

On obtient ainsi un couplage complexe où la part du gain et la part de l'indice optique peuvent être ajustées indépendamment l'une de l'autre puisqu'elles sont fondées sur des principes différents.

On peut même déphaser le réseau de gain par rapport au réseau d'indice en modifiant les positions respectives des maxima de gain et des maxima d'indice.

Dans l'exemple représenté sur la figure 2, si l'indice optique des zones 11 est supérieur à celui des zones 11a, les réseaux sont en opposition de phase et, dans le cas contraire, les réseaux sont en phase.

La modulation spatiale du courant peut être réalisée de différentes manières dans des structures conformes à l'invention, à jonction P-N et à couche de guidage de lumière, en bloquant périodiquement l'arrivée du courant jusqu'à la couche de guidage de lumière.

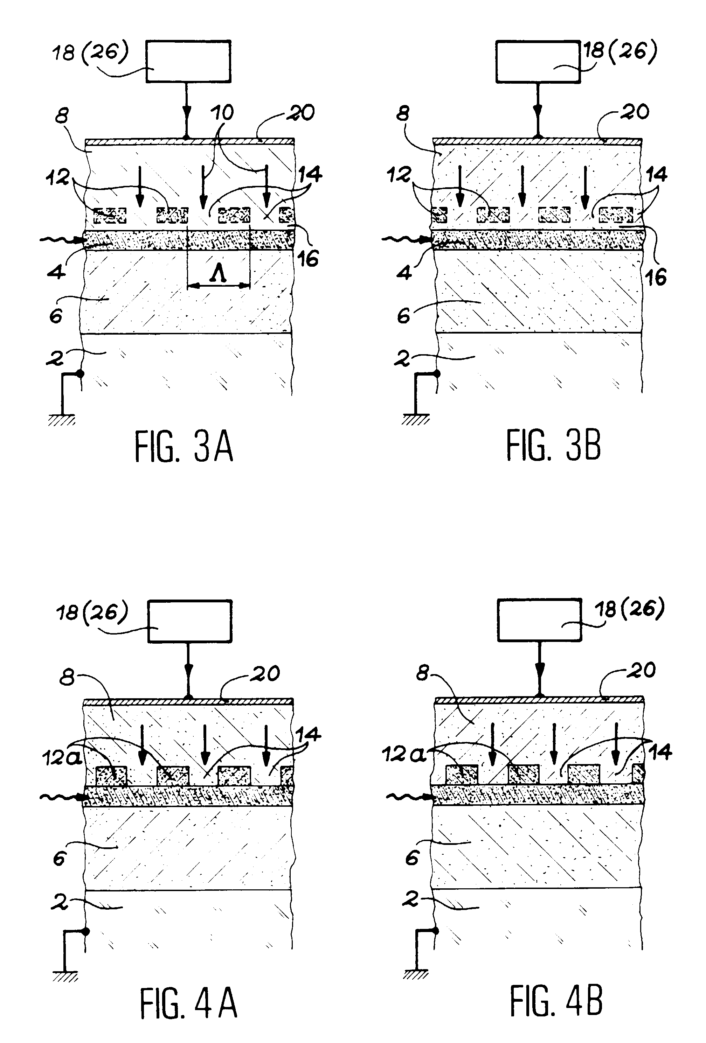

Quelques exemples sont illustrés schématiquement et partiellement par les figures 3A à 4B.

Sur la figure 3A, on voit encore la couche de guidage de lumière 4 (en matériau semiconducteur intrinsèque), comprise entre la couche de confinement inférieure 6, en matériau semiconducteur de type N, et la couche de confinement supérieure 8, en matériau semiconducteur de type P, sur le substrat semiconducteur 2 de type N.

Dans le cas de la figure 3A, l'agencement périodique, de période Λ, comprend des zones 12 qui sont faites d'un matériau semiconducteur de confinement optique, de type N, et situées dans la couche 8, et qui peuvent être au voisinage de la couche 4 (cas de la figure 3A) ou en contact avec celle-ci, ces zones 12 alternant avec des zones 14 faites du matériau constitutif de la couche 8 (semiconducteur de type P).

L'épaisseur de la couche semiconductrice 16 de type P qui peut exister entre l'agencement périodique et la couche 4 est très faible, par exemple inférieure à 50 nm.

La structure représentée sur la figure 3A comprend également des moyens 18 prévus pour injecter un courant dans la couche 8, par l'intermédiaire d'une électrode 20 que comporte cette couche 8, et pour polariser en direct la jonction P-N qui est formée par les couches 6 et 8.

Les zones semiconductrices 12 bloquent, avec la période Λ, l'arrivée du courant à la couche 4.

En effet, au niveau de ces zones 12, on a des jonctions bloquantes de type P-N-I-N alors qu'au niveau des zones 14 ont a des jonctions passantes de type P-I-N.

Une variante de réalisation est schématiquement et partiellement illustrée par la figure 3B où le substrat 2 et la couche de confinement inférieur 6 sont de type P et où la couche de confinement supérieure 8 est de type N.

Les zones 12 sont ici de type P et alternent avec des zones 14 de la couche 8 (de type N).

On peut encore éventuellement prévoir une couche semiconductrice 16 de très faible épaisseur (et de type N dans le cas de la figure 3B) entre la couche 4 et l'agencement périodique où les zones 12 de type P alternent avec les zones 14 de type N.

Dans le cas de cette figure 3B, les moyens 18 sont encore prévus pour injecter un courant dans la couche 8 et pour polariser la jonction P-N en direct.

Le fonctionnement d'une telle structure est similaire à celui de la structure représentée sur la figure 3A.

On précise que le dopage des zones 12 est inférieur à 10¹⁹ cm⁻³, Le dopage de la couche 8 et donc des zones 14 est typiquement entre 5x10¹⁷ cm⁻³ et 2x10¹⁸ cm⁻³.

Dans une autre variante de réalisation schématiquement et partiellement illustrée par la figure 4A, la structure est conforme à celle de la figure 3A excepté qu'il n'y a pas de couche 16 et que les zones 12 sont remplacées par des zones 12a faites d'un matériau semiconducteur non intentionnellement dopé, les zones 14, qui font partie de la couche 8, étant de type P.

Dans ce cas, on obtient des jonctions bloquantes au niveau des zones 12a.

Une autre variante de réalisation est schématiquement et partiellement illustrée par la figure 4B où la structure est identique à celle de la figure 3B excepté qu'il n'y a plus de couche 16 et que les zones 12 sont remplacées par des zones 12a faites d'un matériau semiconducteur non intentionnellement dopé.

Dans ce cas, on obtient encore des jonctions bloquantes au niveau des zones 12a.

On précise que l'épaisseur des zones 12 et des zones 12a est inférieure ou égale à la période de l'agencement dont elles font partie.

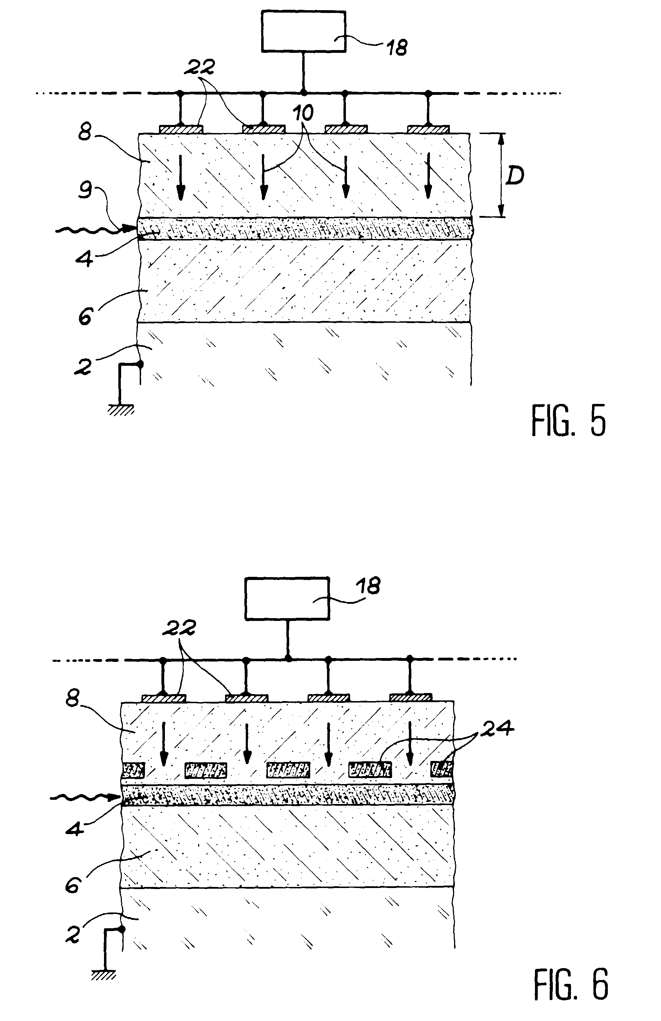

Une autre structure semiconductrice est schématiquement et partiellement représentée sur la figure 5.

Cette structure de la figure 5 est identique à celle de la figure 3A excepté que les zones 12 sont supprimées et l'électrode continue 20 est remplacée par une suite périodique d'électrodes élémentaires 22 formées sur la couche 8 et de période Λ de l'ordre de grandeur de la longueur d'onde de la lumière 9 destinée à être guidée par la structure.

Les moyens 18 permettent encore d'injecter un courant dans chacune des électrodes élémentaires 22 et de polariser en direct la jonction P-N.

On précise que, dans le cas de la structure de la figure 5, il convient que la distance D entre les électrodes élémentaires 22 et la couche de guidage 4 soit de l'ordre de grandeur de la longueur de diffusion des porteurs dans la couche de confinement supérieure 8 ou soit inférieure à cette longueur, pour que la structure fonctionne convenablement.

Dans une variante non représentée de réalisation de la structure de la figure 5, le substrat et la couche de confinement inférieure sont de type P et la couche de confinement supérieure est de type N.

Dans le cas où la couche de guidage 4 est active, les structures conformes à l'invention des figures 3A à 5 permettent d'obtenir un réseau de gain pur et, dans le cas où la couche 4 est passive, d'obtenir des réseaux d'indice.

Pour obtenir un couplage complexe dans le cas où cette couche 4 est active (milieu amplificateur), il suffit, pour les structures des figures 3A à 4B, que l'indice optique des zones 12 diffère de l'indice optique des zones 14.

En choisissant convenablement le matériau constitutif des zones 14 et le matériau constitutif des zones 12, on peut obtenir des indices optiques choisis à l'avance et l'on maîtrise donc l'amplitude du réseau d'indice.

On obtient un réseau de gain en phase avec le réseau d'indice si le plus grand des indices optiques des zones 12 et 14 correspond aux jonctions passantes, où le gain est maximum, et l'on obtient un réseau de gain en opposition de phase avec le réseau d'indice si l'indice optique le plus grand correspond aux jonctions bloquantes.

En ce qui concerne la structure de la figure 5, pour obtenir un couplage complexe, il faut ajouter à cette structure (dont la couche 4 est alors active) un réseau d'indice, comme le montre schématiquement et partiellement la figure 6.

Ce réseau d'indice comprend une suite de zones 24 situées dans la couche de confinement supérieure 8 et donc du côté des électrodes élémentaires 22.

Ces zones 24 sont situées au voisinage de la couche 4, ont la même période que les électrodes élémentaires 22 et sont constituées d'un matériau semiconducteur qui a le même type de dopage que celui de la couche 8 mais qui a un indice optique différent de celui de cette couche 8, ces zones 24 étant disposées en regard des intervalles séparant les électrodes élémentaires 22.

Les agencements périodiques utilisés dans les structures des figures 3A, 3B, 4A et 4B pourraient être réalisés dans la couche de confinement inférieure 6 mais ils le sont de préférence dans la couche de confinement supérieure 8 comme l'illustrent ces figures, ce qui permet l'obtention d'un couplage complexe déterminé (en choisissant convenablement le matériau constitutif des zones 12 et celui des zones 14) sans avoir à intervenir sur la couche active par une gravure.

D'autres structures conformes à l'invention sont réalisables, en remplaçant, dans les structures des figures 3A, 3B, 4A, 4B (qui constituent des dispositifs opto-électroniques à contre-réaction distribuée), les moyens 18 par des moyens 26 qui sont prévus pour polariser la jonction P-N en inverse.

Dans ce cas, la couche de guidage 4 est supposée passive (simple guidage de lumière).

On crée de cette façon un réseau d'indice.

C'est la modulation spatiale du champ électrique dans la jonction (et donc dans la couche de guidage) qui crée ce réseau grâce à des effets électro-optiques.

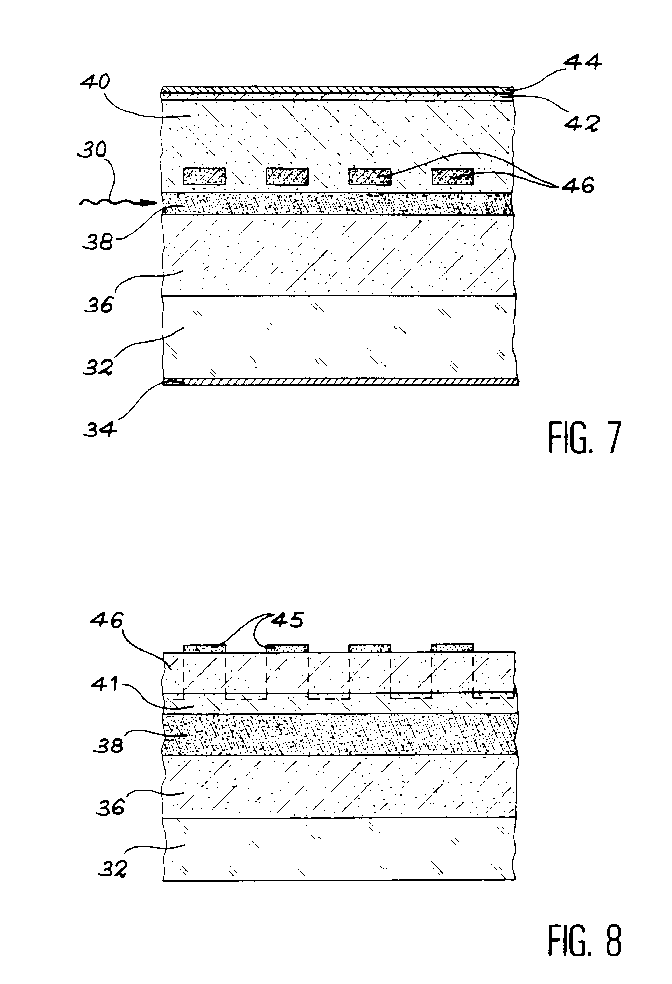

On décrit ci-après un procédé permettant d'obtenir une structure conforme à l'invention qui est schématiquement et partiellement représenté sur la figure 7 et qui constitue un dispositif optoélectronique à contre-réaction distribuée.

Ce dispositif de la figure 7 est un laser GaInAsP/InP à couplage par le gain pur, qui émet une lumière dont la longueur d'onde vaut par exemple 1,5 µm ou 1,3 µm et qui est réalisé sur un substrat semiconducteur de type N.

Le couplage par le gain pur est obtenu grâce à un réseau de zones de type N et de zones de type P qui alternent les unes avec les autres et qui sont faites d'un matériau de confinement optique (InP dans l'exemple choisi).

La différence entre l'indice optique du matériau de type N et l'indice optique du matériau de type P (matériaux qui ont une même largeur de bande interdite) est très faible et peut être complètement annulée par le choix du niveau de dopage.

Dans l'exemple donné, on utilise largement le matériau semiconducteur InP mais il va de soi que l'on pourrait utiliser d'autres matériaux comme par exemple GaAs, et plus généralement des matériaux de type III-V ainsi que des matériaux de type II-VI.

Le laser de la figure 7 est représenté en coupe longitudinale suivant un plan parallèle à la direction de propagation de la lumière 30.

Ce laser comprend en empilement de couches que l'on rencontre dans des structures lasers connues et qui forme un guide optique à double hétérostructure, à savoir :
- un substrat 32 en InP de type N, comportant sur sa face inférieure une électrode en alliage TiAu et, sur sa face supérieure, une couche-tampon 36 en InP dopé N qui constitue une couche de confinement inférieur de lumière,
- sur cette couche-tampon 36, une couche active 38 d'épaisseur 90 nm faite de GaInAsP massif ou composée d'empilement de couches alternées GaInAs/GaInAsP formant une structure active à puits quantiques avec un guide optique en GaInAsP à composition constante ou graduelle mais différente de la composition du matériau des puits quantiques, la structure active correspondant à une émission laser de longueur d'onde ajustée dans la fenêtre 1,5 µm ou la fenêtre 1,3 µm,
- sur la couche active 38, une couche 40 en InP de type P, qui constitue une couche de confinement supérieur de lumière,
- sur cette couche 40, une couche de contact 42 en GaInAs de type P⁺, de 0,2 µm d'épaisseur, sur laquelle est formée une électrode 44 en alliage TiPt (du côté supérieur du ruban actif du laser).

Conformément à l'invention, le dispositif de la figure 7 comprend en outre, du côté de la couche de confinement optique supérieur 40, une couche 46 en InP dopé N, dont l'épaisseur vaut par exemple 50 nm et qui est gravée périodiquement et recouverte par le matériau InP dopé P de la couche de confinement optique supérieur 40, formant ainsi un réseau qui est constitué de zones en InP dopé N séparées par des zones en InP dopé P.

Une très faible épaisseur en InP dopé P peut séparer ce réseau de la couche active 38, comme on le voit sur la figure 7.

A titre purement indicatif et nullement limitatif, on décrit ci-après un procédé de réalisation du dispositif de la figure 7, en prenant l'exemple d'une structure BRS (voir le document (11)).

Les figures 8 à 10 illustrent schématiquement et partiellement des étapes importantes de ce procédé.

Sur un substrat 32 en InP de type N, on dépose successivement, dans un premier cycle d'épitaxie en phase vapeur aux organométalliques ou MOVPE :
- une couche 36 en InP de type N dopé entre 5x10¹⁷ et 3x10¹⁸ cm⁻³,
- une couche active 38 en GaInAsP, de composition correspondant à une émission lumineuse dans le domaine centré sur 1,3 µm ou 1,5 µm suivant ce que l'on souhaite,
- une couche de protection 41 en InP de type P, dont le dopage est compris entre 5x10¹⁶ et 5x10¹⁸ cm⁻³ et l'épaisseur est inférieure à 50 nm et par exemple égale à 20 nm,
- une couche 46 en InP de type N, qui est destinée à la formation du réseau de la figure 7 et dont le dopage est compris entre 5x10¹⁷ et 5x10¹⁸ cm⁻³, l'épaisseur de cette couche 46 étant comprise entre 1 nm et 1000 nm et étant par exemple égale à 50 nm.

On obtient ainsi un empilement qui est vu en coupe longitudinale sur la figure 8.

On effectue ensuite la gravure de la couche 46 à travers un masque 45 obtenu par un masqueur électronique ou par une insolation holographique, pour obtenir un réseau périodique avec une période spatiale proche de la longueur d'onde de la lumière destinée à être guidée dans la couche active.

L'étape suivante consiste à effectuer la gravure du ruban 47 du laser suivant la direction cristallographique <110> ou <110>, mais perpendiculairement aux traits du réseau.

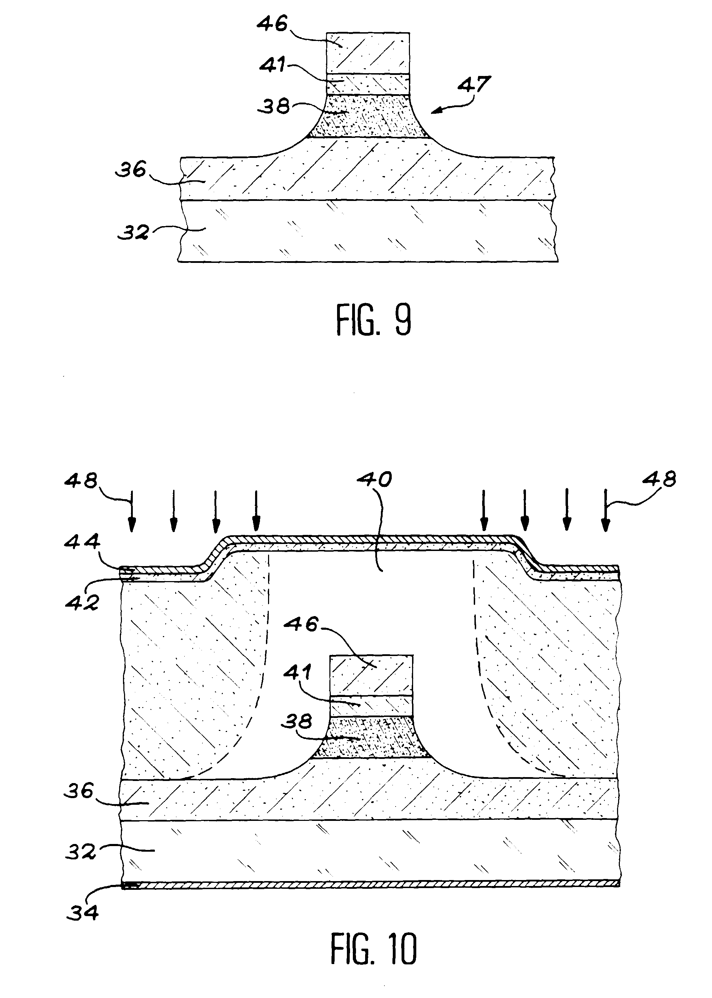

Cette étape est schématiquement illustrée par la figure 9 qui est une vue en coupe transversale du laser en cours de fabrication.

Dans l'exemple décrit, les gravures sont effectuées par voie chimique mais il est possible de les faire aussi par voie sèche, par exemple en utilisant un usinage ionique et/ou un usinage par plasma (gravure ionique réactive ("Reactive Ion Etching") ou gravure par faisceau d'ions ("Ion Beam Etching")).

On procède alors à un deuxième cycle d'épitaxie MOVPE pour faire croître successivement (figure 10) :
- la couche 40 en InP dopé P⁺ entre 1x10¹⁷ cm⁻³ et 1x10¹⁹ cm⁻³ (par exemple 2x10¹⁸ cm⁻³),
- la couche 42 en GaInAs dopée P⁺, entre 1x10¹⁸ cm⁻³ et 2x10¹⁹ cm⁻³ (par exemple 1x10¹⁹ cm⁻³).

On forme ensuite l'électrode supérieure 44 de la diode-laser sur la couche 42, en réalisant un dépôt d'alliage TiPt qui est rechargé en Au.

On dépose ensuite sur la face inférieure du substrat 32 l'électrode inférieure 34 de la diode-laser, qui est en alliage TiAu.

Afin d'obtenir une isolation électrique du reste de la surface, on effectue une implantation ionique de protons (symbolisée par des flèches 48) des deux côtés du ruban du laser, ce qui rend semi-isolante la couche 40 en InP de type P.

On a ainsi réalisé un laser mono-fréquence de type DFB avec un excellent SMSR supérieur à 50 dB.

La plupart des lasers ainsi réalisés restent monofréquence jusqu'au courant maximum que peut supporter la structure, c'est-à-dire 300 à 600 mA CW.

On a pu ainsi obtenir de très bonnes puissances optiques monofréquences, notamment de 40 à 70 mW, et jusqu'à 110 mW pulse, la limite étant due à la résistance thermique du montage.

La preuve de l'existence du couplage par le gain est apportée par le comportement spectral des lasers traités sur les deux faces par des couches antireflet.

On observe déjà sous le seuil un fonctionnement monofréquence qui est maintenu dans une large gamme de courant, contrairement aux lasers qui sont couplés par l'indice et qui, avec les deux faces traitées, auraient un comportement bi-mode très net.

L'invention n'est pas limitée à de tels lasers DFB : elle s'applique également, par exemple, à l'obtention de guides de lumière (à couche guidante passive) munis d'un réseau de Bragg, qui servent par exemple à la réalisation de lasers DBR.

En outre, la présente invention n'est pas limitée à des structures guidant la lumière : elle vise également des structures semiconductrices qui ne guident pas la lumière.

Ceci est expliqué en faisant encore référence à la figure 1.

Dans le cas d'une structure non guidante, la couche 4 ne guide aucune lumière et, de ce fait, peut avoir une épaisseur nettement supérieure à celle qu'elle doit avoit pour guider la lumière.

Dans le cas de la structure non guidante, on envoie la lumière (référencée ici 50) vers la structure, en direction de la face supérieure de celle-ci, l'arrangement ayant encore une période Λ de l'ordre de grandeur de la longueur d'onde de la lumière 50.

Dans ce cas, les électrodes telles que 20 (figure 3A), qui sont utilisées pour la polarisation et la commande de la structure, peuvent être choisies transparentes à cette lumière 50 ou peuvent avoir une structure de grille de façon à laisser passer la plus grande partie de cette lumière.

En l'absence d'injection de courant (ou de polarisation en inverse), il n'y a pas de réseau de diffraction et la lumière 50 traverse la structure dont les matériaux constitutifs sont choisis transparents à la lumière dans le cas considéré ici, d'où un faisceau de sortie 52.

Avec l'injection de courant (ou la polarisation en inverse), le réseau de diffraction est formé et la lumière 50 interagit avec celui-ci pour donner un faisceau diffracté 54.

Dans une variante non conforme à l'invention, la couche 8 (figures 3A à 4B) qui entoure les zones 12 (ou 12a) a un indice optique différent de celui de ces zones 12 (ou 12a) et cette couche 8 peut être surmontée d'une couche complémentaire de confinement ayant un indice optique différent de celui de la couche 8.

Cet exemple non conforme à la présente invention permet donc d'obtenir non seulement un réseau à couplage complexe (gain, indice) mais aussi un réseau d'indice à couplage variable c'est-à-dire un réseau d'indice réel auquel s'ajoute un réseau d'indice virtuel (qu'on peut faire apparaître et varier à la demande).

Les documents cités dans la présente description sont les suivants :
(1) A. Takemoto, Y. Ohkura, H. Watanabe, Y.Nakajima, Y.Sakakibara, S.Kakimoto, H.Namizaki, "Dependence of characteristics of buried grating type DFB laser diodes on the coupling constant", Technical Digest, 12 IEEE International Semiconductor Laser Conference, Sept.92, Davos, Switzerland, paper E-3
(2) W.Streifer, R.D. Burnham, D.R. Scifres, "Effect of External reflectors on longitudinal modes of distributed feedback lasers", IEEE J. Quantum Electron., QE-11(1975), p.154
(3) K. Utaka, S.Akiba, K.Sakai, Y.Matsushima, "Analysis of quarter wave shifted DFB lasers", Electron., Lett., 20(1984), p.326
(4) H.Kogelnik, C.V. Shank, "Coupled wave theory of distributed feedback lasers", J.Appl. Phys. 43 (1972), p.2327
(5) Y.Nakano, Y.Luo, K.Tada, Appl. Phys. Lett., 55(1989), p.1606; mêmes auteurs: Extended Anstracts, 1988 International Conference on Solid State Devices and Materials, Tokyo, 1988, paper D-4-4
(6) B. Borchert, K.David, B.Stegmueller, R.Gessner, M.Beschorner, D.Sacher, G.Franz, IEEE Photon. Technol. Lett., 3(1991), p.955
(7) W.T.Tsang, F.S. Choa, M.C.Wu, Y.K. Chen, R.A.Logan, A.M.Sergent, C.A.Burrus, IEEE Photon. Technol. Lett., 4(1992), p.212
(8) K.Tada, "Gain coupled DFB lasers", Technical Digest, OFC/IOOC'93, San Diego, paper ThB1 (invited)
(9) K.Kudo, J.I. Shim, K.Komori, S.Arai, "Reduction of effective linewidth enhancement factor of DFB laser with complex coupling coefficients", IEEE Photon. Technol. Lett., 4(1992), p.531
(10) Y.Luo, Y.Nakano, K.Tada, T.Inoue, H.Hosomatsu, H.Iwaoka, "Fabrication and characteristics of gain coupled DFB semiconductor lasers with a corrugated active layer", IEEE J.Quantum Electron., 7(1991), p.1724
(11) J.Charil, S.Slempkes, D.Robein, C.Kazmierski, J.C.Bouley, "Extremely low threshold and high power InGaAsP DFB laser diodes", Electron. Lett. 25(1989), p.1477
(12) FR-A-2684498 (MITSUBISHI DENKI K.K.)
(13) JP-A-01124279 (MATSUSHITA ELECTRIC)
(14) C. Kazmierski, D. Robein et Y. Gao, "Universal iron behaviour in Zn-, Cd- and Be- doped p-type InP", J. of crystal growth 116 (1992), p.75.

## Revendications

1. Structure semiconductrice, comprenant :
- une première couche semiconductrice (6) ayant un premier type de dopage,
- une couche semiconductrice intermédiaire (4), qui est placée au dessus de la première couche semiconductrice, et
- une deuxième couche semiconductrice (8) ayant un deuxième type de dopage opposé au premier type, cette deuxième couche semiconductrice étant placée au dessus de la couche semiconductrice intermédiaire, et formant, avec la première couche semiconductrice, une jonction P-N, les largeurs de bande interdite des première et deuxième couches semiconductrices étant supérieures à celle de la couche semiconductrice intermédiaire,
cette structure comprenant en outre, d'un côté de la couche semiconductrice intermédiaire (4), un agencement périodique (12, 14; 12a, 14) qui est apte à moduler spatialement la répartition des porteurs de charge ou le champ électrique dans cette couche intermédiaire, lorsqu'un courant électrique est injecté dans la jonction P-N ou que cette dernière est polarisée en inverse, de manière à créer alors, dans la structure, un réseau de diffraction dont le pas est égal à la période de l'agencement, et l'agencement périodique se trouvant dans l'une des première et deuxième couches semiconductrices et comprenant une suite de premières zones semiconductrices ayant un dopage de l'ordre de 10¹⁷ cm⁻³ à 10¹⁸ cm⁻³ ou inférieur à 10¹⁷ cm⁻³ et de type opposé à celui de la couche semiconductrice dans laquelle se trouve l'agencement périodique, alternant avec des deuxièmes zones semiconductrices ayant le même type de dopage que celui de la couche semiconductrice dans laquelle se trouve l'agencement périodique le réseau de diffraction n'existant pas en l'absence d'injection de courant ou de polarisation en inverse ; caractérisée en ce que l'épaisseur des premières zones semiconductrices est inférieure à la longueur de diffusion des porteurs dans ces premières zones.

2. Structure selon la revendication 1, caractérisée en ce que l'épaisseur desdites premières zones est inférieure ou environ égale à la période de l'agencement périodique.

3. Structure selon l'une quelconque des revendications 1 et 2, caractérisée en ce qu'elle comprend en outre des moyens (18) d'injection de courant électrique dans la jonction P-N, l'agencement périodique étant apte à moduler spatialement l'arrivée du courant électrique dans la couche intermédiaire.

4. Structure selon l'une quelconque des revendications 1 et 2, caractérisée en ce qu'elle comprend en outre des moyens (26) de polarisation en inverse de la jonction P-N, l'agencement périodique étant apte à moduler spatialement champ électrique dans cette jonction P-N.

5. Structure selon l'une quelconque des revendications 1 à 4, caractérisée en ce que l'agencement périodique (12, 14; 12a, 14) est formé du côté de la deuxième couche semiconductrice.

6. Structure semiconductrice selon l'une quelconque des revendications 1 à 5, caractérisée en ce que la couche semiconductrice intermédiaire est une couche de guidage de lumière et en ce que les première et deuxième couches semiconductrices sont des couches de confinement aptes à confiner la lumière dans la couche intermédiaire, de manière à former un dispositif opto-électrique contre-réaction distribuée.

7. Structure selon la revendication 6, caractérisée en ce que la couche guidage de lumière (4) est une couche active qui constitue un milieu amplificateur de lumière, l'agencement périodique permettant ainsi la modulation spatiale du gain de la structure.

8. Structure selon revendication 6, caractérisée en ce que la couche de guidage de lumière (4) est une couche passive qui n'amplifie pas la lumière qu'elle guide, l'agencement périodique permettant ainsi la formation d'un réseau d'indice dans la structure.

9. Structure selon l'une quelconque des revendications 1 à 7, caractérisée en ce que les zones qui alternent les unes avec les autres ont des indices optiques différents l'un de l'autre pour former un réseau d'indice.

## Patentansprüche

1. Halbleiterstruktur, umfassend:
- eine erste Halbleiterschicht (6) mit einem ersten Dotierungstyp,
- eine Halbleiter-Zwischenschicht (4), über dieser ersten Halbleiterschicht angebracht, und
- eine zweite Halbleiterschicht (8) mit einem dem ersten Typ entgegengesetzten zweiten Dotierungstyp, wobei diese zweite Halbleiterschicht sich über der Halbleiter-Zwischenschicht befindet und mit der ersten Halbleiterschicht einen P-N-Übergang bildet, wobei die Breiten des verbotenen Bandes der ersten und der zweiten Halbleiterschicht größer sind als diejenige der Halbleiter-Zwischenschicht,
wobei diese Struktur außerdem auf einer Seite der Halbleiter-Zwischenschicht (4) eine periodische Anordnung (12, 14; 12a, 14) umfasst, die fähig ist, die Verteilung der Ladungsträger oder des elektrischen Feldes in dieser Zwischenschicht räumlich zu modulieren, wenn ein elektrischer Strom in den P-N-Übergang eingespeist wird oder dieser letztere umgekehrt polarisiert bzw. vorgespannt wird, um in der Struktur ein Diffraktionsgitter zu bilden, dessen Teilung gleich der Periode der Anordnung ist, und die periodische Anordnung sich in der ersten oder der zweiten Halbleiterschicht befindet und eine Folge erster Halbleiterzonen mit einer Dotierung in der Größenordnung von 10¹⁷ cm⁻³ bis 10¹⁸ cm⁻³ oder unter 10¹⁷ cm⁻³ des umgekehrten Typs umfasst, bezogen auf den der Halbleiterschicht, in der sich die periodische Anordnung befindet, abwechselnd mit zweiten Halbleiterzonen, die denselben Dotierungstyp wie den der Halbleiterschicht aufweisen, in der sich die periodische Anordnung befindet, wobei das Diffraktionsgitter bei Fehlen von Stromeinspeisung oder umgekehrter Polarisierung bzw. Vorspannung nicht existiert,
**dadurch gekennzeichnet,**
dass die Dicke der ersten Halbleiterzonen kleiner ist als die Diffusionslänge der Träger in diesen ersten Zonen.

2. Struktur nach Anspruch 1, dadurch gekennzeichnet, dass die Dicke der genannten ersten Zonen kleiner oder ungefähr gleich der Periode der periodischen Anordnung ist.

3. Struktur nach einem der Ansprüche 1 und 2, dadurch gekennzeichnet, dass sie außerdem Einrichtungen (18) zum Einspeisen von elektrischem Strom in den P-N-Übergang umfasst, wobei die periodische Anordnung fähig ist, das Ankommen des elektrischen Stroms in der Zwischenschicht räumlich zu modulieren.

4. Struktur nach einem der Ansprüche 1 und 2, dadurch gekennzeichnet, dass sie außerdem Einrichtungen (26) zur umgekehrten Polarisierung bzw. Vorspannung des P-N-Übergangs umfasst, wobei die periodische Anordnung fähig ist, das elektrische Feld in diesem P-N-Übergang räumlich zu modulieren.

5. Struktur nach einem der Ansprüche 1 bis 4, dadurch gekennzeichnet, dass die periodische Anordnung (12, 14; 12a, 14) auf der Seite der zweiten Halbleiterschicht ausgebildet ist.

6. Struktur nach einem der Ansprüche 1 bis 5, dadurch gekennzeichnet, dass die Halbleiter-Zwischenschicht eine Lichtleitschicht ist, und dadurch, dass die erste und die zweite Halbleiterschicht Einschließschichten sind, fähig das Licht in der Zwischenschicht einzuschließen, um eine optoelektrische Vorrichtung mit verteilter Rückkopplung zu bilden.

7. Struktur nach Anspruch 6, dadurch gekennzeichnet, dass die Lichtleitschicht (4) eine aktive Schicht ist, die ein Lichtverstärkungsmedium bildet, wobei die periodische Anordnung die räumliche Modulation der Verstärkung der Struktur ermöglicht.

8. Struktur nach Anspruch 6, dadurch gekennzeichnet, dass die Lichtleitschicht (4) eine passive Schicht ist, die das Licht, das sie leitet nicht verstärkt, wobei die periodische Anordnung die Bildung eines Indexgitters in der Struktur ermöglicht.

9. Struktur nach einem der Ansprüche 1 bis 7, dadurch gekennzeichnet, dass die Zonen, die miteinander abwechseln, voneinander unterschiedliche optische Indices haben, um ein Indexgitter zu bilden.

## Claims

1. Semiconductor structure comprising:
a first semiconductor layer (6) having a first doping type,
an intermediate semiconductor layer (4) placed above the first semiconductor layer and
a second semiconductor layer (8) having a second doping type which is the opposite to the first type, said second semiconductor layer being placed above the intermediate semiconductor layer and forming, with the first semiconductor layer, a p-n junction, the forbidden band widths of the first and second semiconductor layers being greater than that of the intermediate semiconductor layer,
said structure also comprising on one side of the intermediate semiconductor layer (4), a periodic arrangement (12, 14; 12a, 14) able to spatially modulate the distribution of the charge carriers or electric field in said intermediate layer when an electric current is injected into the p-n junction or the latter is reverse biased, so as to then create in the structure a diffraction grating, whose pitch spacing is equal to the period of the arrangement, and the periodic arrangement in one of the first and second semiconductor layers and consisting of a sequence of first semiconductor zones having a doping of approximately 10¹⁷ cm⁻³ to 10¹⁸ cm⁻³ or below 10¹⁷ cm⁻³ and of type opposite to that of the semiconductor layer in which is located the periodic arrangement, alternating with second semiconductor zones having the same doping type as that of the semiconductor layer in which the periodic arrangement is located the diffraction grating not existing in the absence of current injection or reverse bias, characterized in that the thickness of the first semiconductor zones is less than the diffusion length of the carriers in said first zones.

2. Structure according to claim 1, characterized in that the thickness of said first zones is less or approximately equal to the period of the periodic arrangement.

3. Structure according to either of the claims 1 and 2, characterized in that it also incorporates means (18) for injecting an electric current into the p-n junction, the periodic arrangement being able to spatially modulate the entry of current in the intermediate layer.

4. Structure according to either of the claims 1 and 2, characterized in that it also incorporates means (26) for the reverse biasing of the p-n junction, the periodic arrangement being able to spatially modulate the electric field in said p-n junction.

5. Structure according to any one of the claims 1 to 4, characterized in that the periodic arrangement (12, 14, 12a, 14) is formed on the side of the second semiconductor layer.

6. Semiconductor structure according to any one of the claims 1 to 5, characterized in that the intermediate semiconductor layer is a light guidance layer and in that the first and second semiconductor layers are confinement layers able to confine light in the intermediate layer, so as to form a distributed feedback optoelectronic device.

7. Structure according to claim 6, characterized in that the light guidance layer (4) is an active layer constituting a light amplifying medium, the periodic arrangement thus permitting the spatial modulation of the gain of the structure.

8. Structure according to claim 6, characterized in that the light guidance layer (4) is a passive layer, which does not amplify the light which it guides, the periodic arrangement thus permitting the formation of an index grating in the structure.

9. Structure according to any one of the claims 1 to 7, characterized in that the zones alternating with one another have different optical indexes in order to form an index grating.
